# EUROPEAN PATENT SPECIFICATION

(11) **EP 0 841 731 B1**
(45) Date of publication and mention of the grant of the patent: **20.01.1999**
(21) Application number: 97308571.5
(22) Date of filing: 28.10.1997
(51) Int. Cl.: H01S 3/18

(54) **Quantum cascade laser**
Quantum Cascade Laser
Quantum cascade laser

(30) Priority: 06.11.1996 US 744292; 29.04.1997 US 841059
(43) Date of publication of application: 13.05.1998
(73) Proprietor: LUCENT TECHNOLOGIES INC., Murray Hill, New Jersey 07974-0636 (US)
(72) Inventor: Capasso, Federico, Westfield, New Jersey 07090 (US); Faist, Jerome, Scotch Plains, New Jersey 07076 (US); Cho, Alfred Yi, Summit, New Jersey 07901 (US); Hutchinson, Albert Lee, Piscataway, New Jersey 08854 (US); Scamarcio, Gaetano, 70124 Bari (IT); Sirtori, Carlo, Summit, New Jersey 07901 (US); Sivco, Deborah Lee, Warren, New Jersey 07059 (US)
(74) Representative: Watts, Christopher Malcolm Kelway, Dr.

(56) References cited:
- US-A- 5 509 025
- FAIST J ET AL: "CONTINUOUS WAVE OPERATION OF A VERTICAL TRANSITION QUANTUM CASCADE LASER ABOVE T=80 K" APPLIED PHYSICS LETTERS, vol. 67, no. 21, 20 November 1995, pages 3057-3059, XP000544238
- HELM M: "FAR-INFRARED EMISSION AND ABSORPTION SPECTROSCOPY OF QUANTUM WELLS AND SUPERLATTICES" INTERSUBBAND TRANSITIONS IN QUANTUM WELLS, CARGESE, FR., SEPT. 9 - 14, 1991, no. -, 9 September 1991, ROSENCHER E;VINTER B; LEVINE B, pages 151-161, XP000314289
- G. SCAMARCIO, F. CAPASSO ET AL: "High power infrared (8 micrometer) superlattice lasers" SCIENCE., vol. 276, no. 5313, 2 May 1997, US, pages 773-776, XP002052076

## Description

### Background

Recently a new type of semiconductor laser, designated "quantum cascade" or "QC" laser, was discovered. See, for instance, US patents 5,457,709 and 5,509,025.

Known QC lasers are unipolar semiconductor lasers that have a core region that comprises a multiplicity of essentially identical repeat units, each repeat unit comprising one or more quantum wells (QWs). Successive carrier transitions from a higher to a lower energy state result in photon emissions, with the photon energy depending on the structural and compositional details of the repeat units. Thus, QC lasers can be designed to emit radiation at substantially any desired wavelength in a rather wide spectral region. Specifically, they can be designed to emit in the mid-infrared (mid-IR), a spectral region for which there are few convenient radiation sources.

Although several types of QC lasers are known, it would clearly be desirable if further types were known, since this would give designers increased design freedom, and possibly provide improved characteristics. This application discloses a new type of QC laser.

### Glossary and Definitions

A "quantum well" ("QW") herein is a (generally planar) semiconductor region of a first effective composition that is sandwiched between two semiconductor regions (barrier layers) of a second effective composition, generally selected to have a larger bandgap energy than the first effective composition. The spacing between the two barrier layers (and thus the thickness of the quantum well) is selected such that the relevant charge carriers (typically electrons) exhibit quantum effects in the direction normal to the QW. Typically the carrier energy is quantized in the direction normal to the QW, with the well exhibiting one or more discrete energy levels.

By "effective composition" we mean herein the average composition of a semiconductor region, exemplarily a superlattice region or a digitally graded alloy region. The effective composition is the thickness-weighted average of the barrier composition and QW composition. Such a region is frequently referred to as a "superlattice alloy", or "digital alloy".

By a "superlattice" we mean herein a (frequently periodic) multiplicity of QWs (exemplarily five or more), with a barrier layer between consecutive QWs, and with layer spacings such that the carrier energy states are not localized to individual QWs but instead extend throughout the superlattice region. A digital alloy is considered to be a superlattice, whereas a superlattice is not necessarily a digital alloy, depending on QC and barrier thicknesses.

A "miniband" herein is an energy region, generally associated with a superlattice, that contains a multiplicity of (typically relatively narrowly spaced), non-localized carrier energy states. Due to the presence of spatially extended energy states, minibands can provide efficient carrier transport. If there are two or more minibands associated with a given superlattice, then two adjacent minibands are separated by a minigap, i.e., an energy region devoid of carrier energy states. Thus, carrier transport through a minigap region is by tunneling and is generally very limited. For a given choice of QW and barrier materials, miniband and minigap widths can be engineered by suitable choice of layer thicknesses. Superlattices can be formed by known growth techniques, e.g., by MBE.

### Summary of the Invention

The invention is defined by claim 1. Various embodiments of the invention are defined by the dependent claims. The invention is embodied in an article (e.g., an absorption measurement system) that comprises a novel QC laser. The laser comprises a first and a second cladding region and a core region between the cladding regions. The core region has higher effective refractive index than the cladding region, the combination thus forming an optical waveguide. The laser further comprises electrical contacts selected to facilitate flowing an electrical current through the laser.

The core region comprises a multiplicity of essentially identical (i.e., nominally identical, differing only due to, typically unavoidable, manufacturing variations) multilayer semiconductor repeat units. Each repeat unit comprises an active region and a carrier injector region. The active region has an upper and a lower energy state, with carrier (typically electron) transition from the upper to the lower energy state resulting in emission of a photon of wavelength λ, exemplarily in the range 3-15 µm.

Significantly, the active region of a given repeat unit comprises a strongly coupled, doped superlattice region having an upper and a lower miniband, with a minigap between the upper and lower minibands. The upper energy state is in the upper miniband (typically at the lower edge thereof), and the lower energy state is in the lower miniband (typically at the upper edge thereof), the carrier concentration in the doped superlattice region being large enough to minimize electric field penetration into the superlattice region and space charge build-up under high current injection which could break up the minibands via field-induced localizations and low enough for the quasi-Fermi level to be well below the top of the lower miniband to minimize thermal occupation of these states at room temperature or even higher. Furthermore, the carrier injector region is selected to facilitate carrier transport from the lower miniband of the given repeat unit to the upper miniband of the adjacent (downstream) repeat unit. The carrier injector region preferably is a digitally graded alloy region but could be an analog graded alloy region.

In pictorial terms, in a QC laser according to the invention, an electron moves down an energy "staircase", emitting a photon of wavelength λ every time it drops down a "step" from an upper to a lower miniband, and moving to the next "edge" by conduction through a carrier injector region.

### Brief Description of the Drawings

FIG. 1 shows a conduction band diagram of a portion of the core of an exemplary QC laser according to the invention;
FIG. 2 shows the calculated dispersion of the lowest two minibands of the exemplary QC laser in the reduced Brillouin scheme;
FIG. 3 shows curves of optical power vs. photon energy of an exemplary QC laser according to the invention;
FIG. 4 shows the high resolution spectrum of the laser of FIG. 3; and
FIG. 5 shows data on power vs. current for an exemplary QC laser according to the invention.

### Detailed Description

Lasers according to this invention exhibit lasing transitions between minibands using unipolar injection. Thus, they use a novel lasing transition not suggested by the prior art.

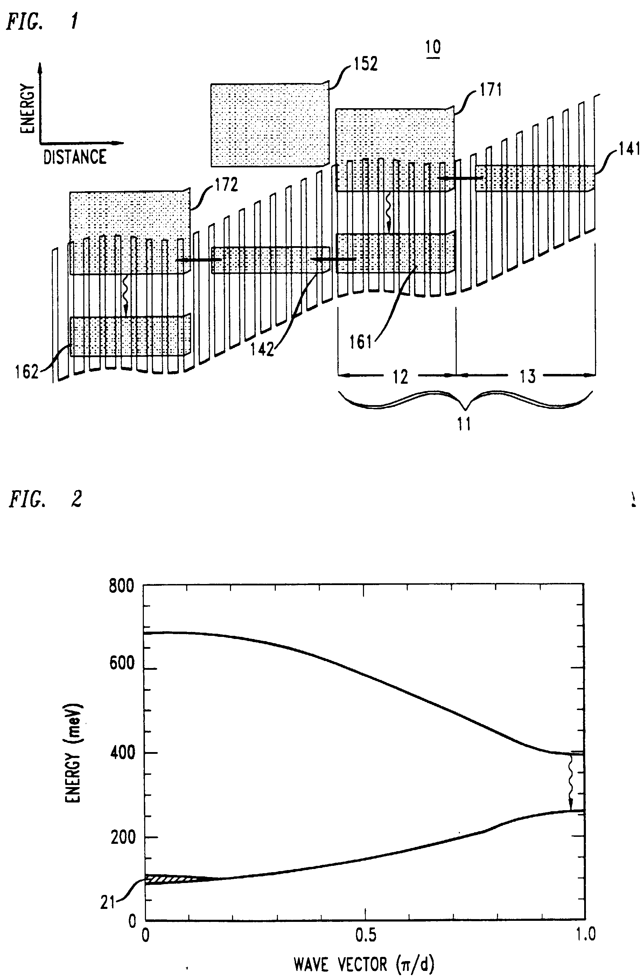

FIG. 1 shows a calculated conduction band diagram of a portion (2 of, exemplarily, 25 repeat units) of the core region of a QC laser according to the invention. Electrons are injected by tunneling into the upper miniband of the n-doped superlattice active regions. Laser action (indicated by wavy arrows) occurs at the minigap between filled energy states at the bottom of the upper miniband and empty energy states at the top of the lower miniband. The digitally graded AlInGaAs injectors comprise short-period n-type doped AlInAs/GaInAs superlattices with varying duty cycles.

More specifically, FIG. 1 shows the conduction band edge of 2 repeat units, with distance normal to the layer structure of the laser being shown along the abscissa, and energy along the ordinate. Numeral 11 indicates one repeat unit, and numerals 12 and 13 respectively indicate the active region and the injector of the repeat unit. Numeral 141 indicates the lowest injector conduction band, and numerals 161 and 171 refer, respectively, to the lower and upper minibands of the active region of one repeat unit, and numerals 162 and 172 refer to the upper and lower minibands of the neighboring (downstream) repeat unit. Electron transport from lower miniband 161 to upper miniband 172 is through injector conduction band 142. Numeral 152 refers to the injector upper conduction band. It plays no significant role in laser action of the exemplary QC laser. The width of the minigap between the active region minibands is a design parameter that determines the lasing wavelength λ. In FIG. 1, straight arrows indicate electron transport in the downstream direction, and wavy arrows indicate the lasing transition.

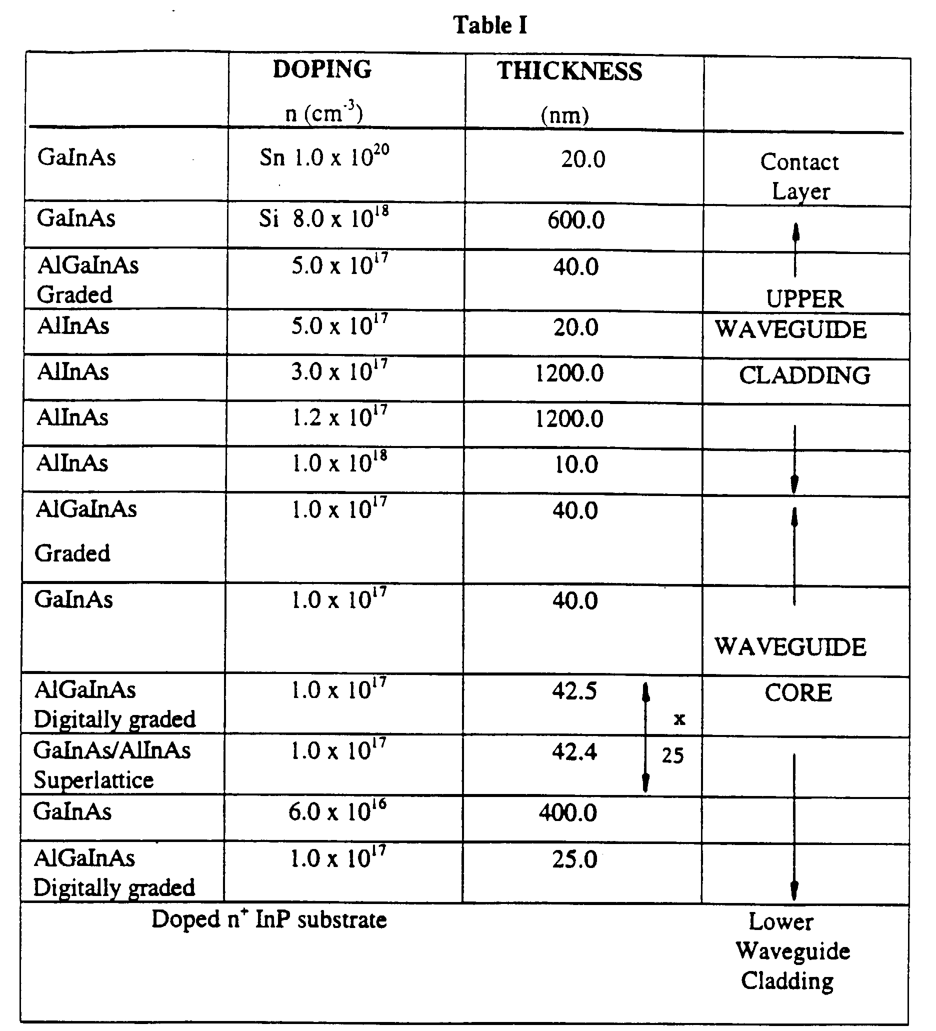

Table I shows the layer structure of an exemplary QC laser according to the invention, designed for emission of ∼ 8 µm IR radiation. The structure comprises 25 repeat units, each consisting of a digitally graded injector and an eight period superlattice with 1 nm thick Al_{0.48}In_{0.52}As barriers and 4.3 nm thick Ga_{0.47}In_{0.53}As QWs. As can be seen from Table I, the layer structure is n-doped. This is a significant difference from previously disclosed QC lasers, wherein at least part of the layer structure was undoped. In the instant laser the dopant was Si in all but the contact layer, where it was Sn.

The waveguide effective refractive index differences between the core and the respective claddings provide the optical confinement necessary for propagation of the radiation parallel to the layers. Our calculations show that the exemplary structure has a confinement factor Γ = 0.32, and a core effective index n_{eff} = 3.21. The lasing mode is polarized normal to the layers (TM mode) as required by the selection rule for interminiband transitions. The top cladding comprises a 2.4 µm thick AlInAs layer. This thickness is necessary because of the relatively long wavelength in the material. The heavily doped 600 nm thick GaInAs layer below the contact layer serves to achieve a high Γ and to reduce waveguide losses by reducing coupling to the plasmon mode (that propagates along the semiconductor/metal contact interface) without growing a too thick AlInAs cladding layer. See US patent 5,502,787. The lower cladding is the InP substrate. This choice of lower cladding substantially reduces the thermal impedance of the structure, compared to the use of AlInAs.

The choice of carrier concentration in the doped superlattice active regions is an important design consideration. The density must be large enough to minimize electric field penetration into the superlattice region and space charge build-up under high current injection (which could break up the minibands via field-induced localization). The carrier concentration must also be low enough for the quasi-Fermi level to be well below the top of the lower miniband to minimize thermal occupation of these states even at higher temperatures (e.g., room temperature or even higher). These design considerations resulted in the choice of n = 1x10¹⁷cm⁻³ in the exemplary QC laser according to the invention.

Each 42.5 nm thick injector consists of a uniformly doped (n = 1x10¹⁷cm⁻³) Al_{0.48}In_{0.52}As/Ga_{0.42}In_{0.53}As graded bandgap superlattice alloy with constant period (5.3 nm) and varying AlInAs/GaInAs thickness ratio. Under an appropriate voltage, the conduction band in the injector acquires a flat profile and electrons are transported through the injector into the superlattice. The onset of strong injection into the downstream upper active region miniband occurs when the bottom of the latter is approximately lined up with that of the conduction band in the injector. In the exemplary laser this corresponds to an applied voltage per period of about 0.3V and to a total voltage of about 7.5V. By way of example, the injector layer sequence of the QC of Table I is 3.6/1.7/3.3/2.0/3.0/2.3/2.6/2.7/2.2/3.1/1.9/3.4/1.6/3.7/1.4/4.0,.where all thicknesses are in nm, and underlined thicknesses pertain to the QWs.

The 25 nm thick digitally graded region on the InP substrate serves as relaxation region. Its layer sequence is 0.5/4.5/1.0/4.0/1.5/3.5/2.0/3.0/2.5/2.5, with all thicknesses being in nm, and the underlined thicknesses being the QWs. The QWs have composition Ga_{0.47}In_{0.53}As, and barriers have composition Al_{0.48}In_{0.52}As.

An advantageous feature of QC lasers according to this invention is the generally high oscillator strength of the lasing transition, i.e., the direct radiative transition between states at the bottom of the upper active region miniband and states at the top of the lower active region miniband. The oscillator strength increases with wavevector k_{z}. The wavevector attains maximum value π/d at the mini-Brillouin zone boundary of the active region superlattice. In particular, the oscillator strength strongly increases with decreasing barrier layer thickness. By way of example, in the above described QC laser the ratio of oscillator strength at k_{z} = π/d and k_{z} = 0 is about 60. In the above discussion, d is the superlattice period.

FIG. 2 shows the calculated dispersion in the reduced Brillouin zone scheme of the lower and upper minibands of the superlattice active region of the exemplary QC laser. The wavevector k_{z} perpendicular to the layers is in units of the value at the minizone boundary (k_{z} = π/d). The calculated widths of the lower and upper minibands are 146 and 300 meV, respectively. The wavy arrow indicates the lasing transition. The photon energy is calculated to be 159 meV, in good agreement with measurements. Shaded region 21 indicates the range of occupied electronic states in the lower miniband.

Measurements also confirm that the luminescence spectrum of the exemplary layer structure typically is dominated by optical transition at the zone boundary. This is generally true even for injection into the upper miniband well above the bottom of the miniband. This is attributed to the ultrafast intraminiband relaxation (≤ 1 ps) by emission of optical phonons, and to the large matrix element (z₂₁ ∼ 3.6 nm) of the zone boundary optical transition.

QC lasers according to this invention generally exhibit the advantageous feature that population inversion is ensured by the fact that the lifetime τ₁ of an electron at the top of the active region lower miniband is substantially negligible (τ₁ ∼ 0.1 ps), as compared to the scattering time τ₂₁ of the electrons in the upper state of the lasing transition
(τ₂₁ ∼ 10 ps). This large difference can be attributed to the much greater momentum transfer for the inter-miniband optical transition, compared to the intra-miniband transitions.

Carrier lifetime in the lower energy state is controlled by intraminiband phonon emission and is inherently short. For λ in the range 3-15 µm it is generally much shorter than the interminiband scattering time. Thus, the population inversion condition is relatively insensitive to wavelength, simplifying the design of the laser.

In QC lasers according to the invention, injection of carriers into the upper miniband is by interminiband tunneling, as indicated in FIG. 1. Onset of strong injection into the upper miniband occurs when the applied voltage is such that the bottom of the upper miniband is approximately lined up with the bottom of the injector conduction band, exemplarily at about 0.3 V/repeat unit.

A wafer with the above-described layer structure was lithographically processed into mesa etched (10 µm-20 µm) wide ridge waveguides. The length of the optical cavity (1.9 mm) was defined by cleaving of the wafer. The cleaved uncoated facets provide the optical feedback in conventional manner. Six devices were tested and exhibited laser action with very similar spectra.

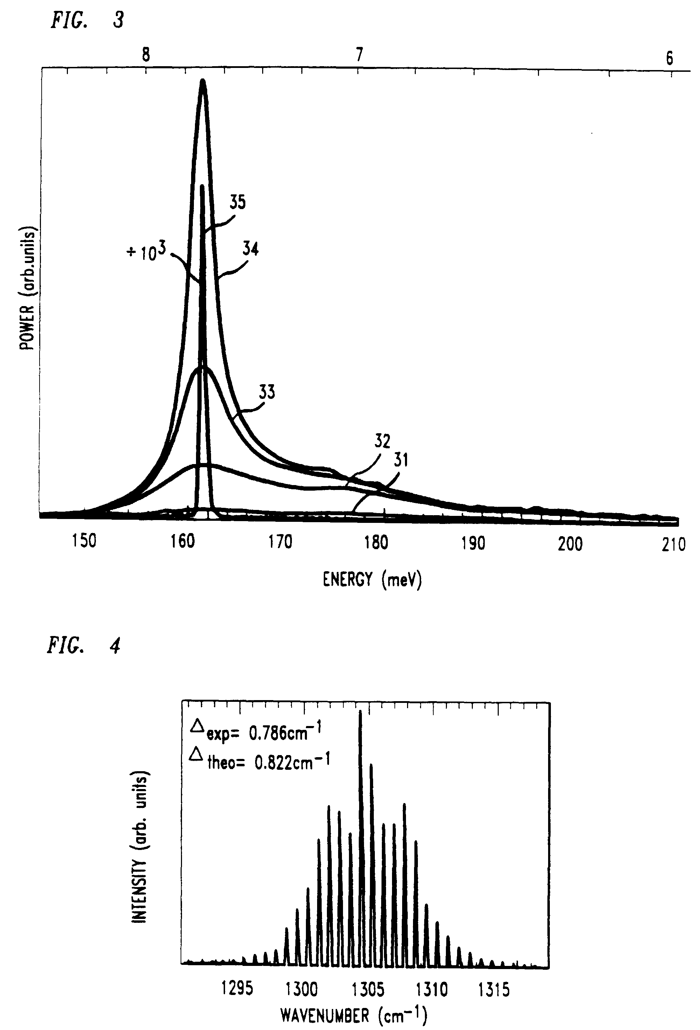

The devices, soldered to a ceramic holder, were mounted in a Helitran® flow dewar. Current pulses (70 ns duration, 100 kHz repetition rate) were injected into a device and the emission spectrum was recorded with a Nicolet Fourier-transform IR spectrometer using a HgCdTe cooled detector. FIGs. 3 and 4 show exemplary results. Curves 31-34 of FIG. 3 show emission below threshold, at various bias conditions, namely, (1.48A, 7.5V), (1.58A, 7.6V), (1.69A, 7.67V), and (1.71A, 7.7V), respectively. Curve 35 of FIG. 3 shows the emission spectrum at 1.75A and 7.73V, and demonstrates laser action. Note that curve 35 is scaled down by 10³, compared to the sub-threshold curves. The laser photon energy of 161 meV was in excellent agreement with the calculated value of the active region minigap.

FIG. 4 shows the high-resolution spectrum of the device of FIG. 3, at 1.72A and 7.7V. The measured longitudinal mode separation (Δₑₓₚ) is in good agreement with the theoretical value Δₜₕ.

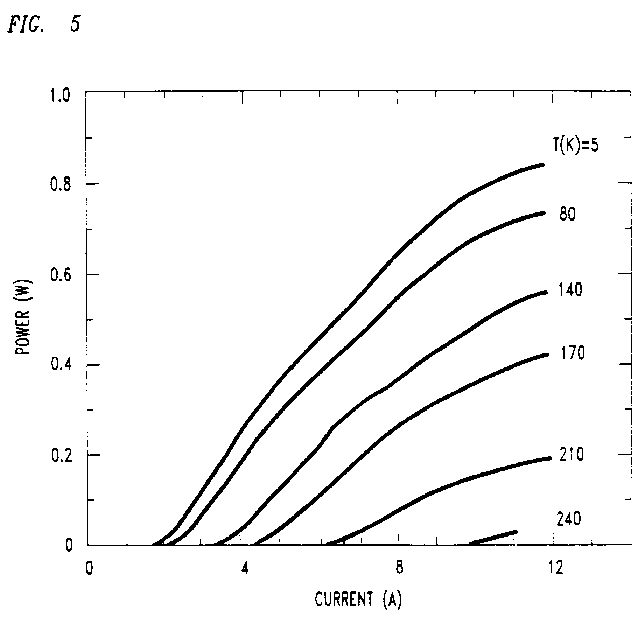

FIG. 5 shows the measured peak optical power as a function of drive current, at various device temperatures, for an exemplary device as described above. The maximum operating temperature for the exemplary, non-optimized QC laser was 240K, with optical power at that temperature as high as 30 mW.

We also made a laser that emitted at 11 µm. The laser was made substantially as described, except that the layer thicknesses were changed in appropriate manner. The laser functioned as expected.

## Claims

1. An article comprising a quantum cascade laser comprising a first and a second cladding region, with a core region therebetween, the core region having a higher effective refractive index than the cladding region, thus forming an optical waveguide, and further comprising electrical contacts selected to facilitate flowing an electrical current through the laser, wherein the core region comprises a multiplicity of essentially identical multilayer semiconductor repeat units (11), each repeat unit comprising an active region (12) and a carrier injector region (13), the active region having an upper and a lower energy state, with carrier transition from the upper to the lower energy state resulting in emission of a photon of wavelength λ;
**CHARACTERIZED IN THAT**
a) the active region comprises a doped superlattice region having an upper (171) and a lower (161) miniband, with a minigap between the upper and lower minibands, with the upper energy state being in the upper miniband and the lower energy state being in the lower miniband, the carrier concentration in the doped superlattice region being large enough to minimize electric field penetration into the superlattice region and space charge build-up under high current injection which could break up the minibands via field-induced localizations and low enough for the quasi-Fermi level to be well below the top of the lower miniband to minimize thermal occupation of these states at room temperature or even higher; and
b) the carrier injector region is selected to facilitate carrier transport from the lower miniband of a given repeat unit to the upper miniband of an adjacent downstream repeat unit.

2. Article according to claim 1, wherein the active region is selected such that λ is in the wavelength range 3-15 µm.

3. Article according to claim 1, wherein the carriers are electrons.

4. Article according to claim 1, wherein the core region comprises 10 or more repeat units.

5. Article according to claim 3, wherein at least the active regions comprise doped semiconductor material.

6. Article according to claim 1, wherein the core region has an effective refractive index that is larger than the effective refractive indices of the first and second cladding regions.

7. Article according to claim 6, wherein at least one of said first and second cladding regions comprises a binary semiconductor material.

8. Article according to claim 7, wherein said binary semiconductor material is doped InP, said doped InP serving as a substrate for the core region.

## Patentansprüche

1. Gegenstand mit einem Quantenkaskadenlaser mit einem ersten und einem zweiten Claddingbereich, mit einem Kernbereich dazwischen, wobei der Kernbereich einen höheren wirksamen Brechungsindex als der Claddingbereich aufweist, wodurch ein Lichtwellenleiter gebildet wird, und weiter mit elektrischen Kontakten, die so gewählt sind, daß das Fließen eines elektrischen Stroms durch den Laser erleichtert wird, wobei der Kernbereich mehrere im wesentlichen identische mehrlagige Halbleiterwiederholeinheiten (11) umfaßt, wobei jede Wiederholeinheit einen aktiven Bereich (12) und einen Trägerinjektorbereich (13) umfaßt, wobei der aktive Bereich einen oberen und einen unteren Energiezustand aufweist, wobei ein Trägerübergang vom oberen zum unteren Energiezustand zur Emission eines Photons der Wellenlänge λ führt;
dadurch gekennzeichnet, daß
a) der aktive Bereich einen dotierten Supergitterbereich mit einem oberen (171) und einem unteren (161) Miniband mit einem Minibandabstand zwischen dem oberen und dem unteren Miniband aufweist, wobei der obere Energiezustand im oberen Miniband und der untere Energiezustand im unteren Miniband auftritt, wobei die Trägerkonzentration im dotierten Supergitterbereich groß genug ist, das Eindringen des elektrischen Feldes in den Supergitterbereich und den Raumladungsaufbau bei Hochstrominjektion, was die Minibänder über feldinduzierte Lokalisierungen aufbrechen könnte, auf ein Minimum zu reduzieren, und niedrig genug ist, damit das Quasi-Fermi-Niveau deutlich unter der Oberkante des unteren Minibands ist, um die thermische Belegung dieser Zustände bei Raumtemperatur und selbst darüber auf ein Minimum zu reduzieren; und
b) der Trägerinjektionsbereich so gewählt ist, daß der Trägertransport vom unteren Miniband einer gegebenen Wiederholeinheit zu dem oberen Miniband einer benachbarten nachgeschalteten Wiederholeinheit erleichtert wird.

2. Gegenstand nach Anspruch 1, bei dem der aktive Bereich derart gewählt ist, daß λ im wellenlängenbereich 3 - 15 µm liegt.

3. Gegenstand nach Anspruch 1, bei dem die Träger Elektronen sind.

4. Gegenstand nach Anspruch 1, bei dem der Kernbereich 10 oder mehr Wiederholeinheiten umfaßt.

5. Gegenstand nach Anspruch 3, bei dem mindestens die aktiven Bereiche aus dotiertem Halbleitermaterial sind.

6. Gegenstand nach Anspruch 1, bei dem der Kernbereich einen effektiven Brechungsindex aufweist, der größer ist als die effektiven Brechungsindizes des ersten und des zweiten Fasermantelbereichs.

7. Gegenstand nach Anspruch 6, bei dem mindestens einer des ersten und des zweiten Fasermantelbereichs aus einem binären Halbleitermaterial besteht.

8. Gegenstand nach Anspruch 7, bei dem das binäre Halbleitermaterial dotiertes InP ist, wobei das dotierte InP als Substrat für den Kernbereich dient.

## Revendications

1. Article comprenant un laser en cascade quantique comprenant une première et deuxième région de gaine, avec une région de coeur entre elles, la région de coeur ayant un indice de réfraction efficace supérieur à celui de la région de gaine, formant ainsi un guide d'ondes optique, et comprenant en outre des contacts électriques sélectionnés pour faciliter le passage d'un courant électrique à travers le laser, dans lequel la région de coeur comprend une multiplicité d'unités de répétition à semi-conducteur multicouche essentiellement identiques (11), chaque unité de répétition comprenant une région active (12) et une région d'injection de porteurs (13), la région active ayant un état d'énergie supérieur et inférieur, la transition de porteurs depuis l'état d'énergie supérieur à l'état d'énergie inférieur résultant en l'émission d'un photon de longueur d'onde λ ;
CARACTERISE EN CE QUE
a) la région active comprend une région de super-réseau dopée ayant une minibande supérieure (171) et une minibande inférieure (161), avec une minibande interdite entre les minibandes supérieure et inférieure, l'état d'énergie supérieur étant dans la mini-bande supérieure et l'état d'énergie inférieur étant dans la mini-bande inférieure ; la concentration de porteurs dans la région de super-réseau dopée étant assez grande pour minimiser la pénétration du champ électrique dans la région de super-réseau et l'accumulation de charge dans l'espace en condition d'injection de courant élevée qui pourraient rompre les minibandes par l'intermédiaire de localisations induites par le champ et assez faible pour que le quasi-niveau de Fermi soit bien en dessous du haut de la minibande inférieure en vue de minimiser l'occupation thermique de ces états à température ambiante ou même à une température supérieure ; et
b) la région d'injection de porteurs est sélectionnée pour faciliter le transport de porteurs depuis la minibande inférieure d'une unité de répétition donnée jusqu'à la minibande supérieure d'une unité de répétition aval adjacente.

2. Article selon la revendication 1, dans lequel la région active est sélectionnée de telle sorte que λ soit dans la plage de longueurs d'ondes de 3 à 15 µm.

3. Article selon la revendication 1, dans lequel les porteurs sont des électrons.

4. Article selon la revendication 1, dans lequel la région de coeur comprend 10 unités de répétition ou plus.

5. Article selon la revendication 3, dans lequel au moins les régions actives comprennent un matériau semi-conducteur dopé.

6. Article selon la revendication 1, dans lequel la région de coeur a un indice de réfraction efficace qui est supérieur aux indices de réfraction efficaces des première et deuxième régions de gaine.

7. Article selon la revendication 6, dans lequel au moins une desdites première et deuxième régions de gaine comprend un matériau semi-conducteur binaire.

8. Article selon la revendication 7, dans lequel ledit matériau semi-conducteur binaire est de l'InP dopé, ledit InP dopé servant de substrat à la région de coeur.
